(19) Europäisches Patentamt

European Patent Office

Office européen des brevets

(11) Veröffentlichungsnummer: **0 308 520 B1**

## (12) EUROPÄISCHE PATENTSCHRIFT

(45) Veröffentlichungstag der Patentschrift: **09.12.92**

(21) Anmeldenummer: **87112371.7**

(22) Anmeldetag: **26.08.87**

(51) Int. Cl.⁵: **H03D 1/22**, H04H 1/00

(54) **Digitaler Demodulator.**

(43) Veröffentlichungstag der Anmeldung:
**29.03.89 Patentblatt 89/13**

(45) Bekanntmachung des Hinweises auf die
Patenterteilung:
**09.12.92 Patentblatt 92/50**

(84) Benannte Vertragsstaaten:
**DE FR NL**

(56) Entgegenhaltungen:
**EP-A- 0 124 031**
**WO-A-84/03807**
**DE-A- 3 433 592**
**GB-A- 2 068 686**
**US-A- 4 404 430**

**FUNKSCHAU, Band 58, Nr. 1, Januar 1986,
Seiten 43-47, München, DE; H. DERNEDDE-
JESSEN et al.: "Neue Entwicklung auf Hörfunkwellen"**

**FUNKSCHAU, Band 46, Nr. 14, 5. Juli 1974,
Seiten 535-538, München, DE; J. CONRAD:
"Grünes Licht für den Verkehrsfunk"**

(73) Patentinhaber: **Deutsche ITT Industries GmbH
Hans-Bunte-Strasse 19 Postfach 840
W-7800 Freiburg i.Br.(DE)**

(72) Erfinder: **Reich, Werner, Dr. Ing.
Kleiststrasse 2a
W-7830 Emmendingen(DE)**

## Beschreibung

Die Erfindung betrifft einen digitalen Demodulator nach dem Oberbegriff des Patentanspruchs 1. Ein derartiger digitaler Demodulator ist in der Offenlegungsschrift DE-A-33 14 603 als Teil einer digitalen Quadraturamplitudenmodulations- und -demodulationsschaltung beschrieben.

Die Aufgabe der in den Ansprüchen gekennzeichneten Erfindung besteht darin, ausgehend von der vorbeschriebenen Demodulatorschaltung einen digitalen Demodulator für ein schon digitalisiertes Standard-Stereo-Multiplex-Signal (= MPX-Signal) anzugeben. Ein möglicher Stereo-Multiplex- Standard für FM-Rundfunksignale ist beispielsweise in "Funkschau", 1974, Seiten 535 bis 538 und 1986, Heft 1, Seiten 43 bis 47 beschrieben. Danach liegt bei 57 kHz ein zusätzlicher schmalbandiger Informationskanal, wobei die 57 kHz das Dreifache der Stereopilotsignalfrequenz sind.

Durch die Erfindung ergibt sich unter anderem der Vorteil, daß durch die digitale Frequenzumsetzung bei der Demodulation eine gleichbleibende Qualität der Trennung der Signalkomponenten des MPX-Signals erfolgt, da Alterung und Temperatur ohne Einfluß auf die Demodulatoren und die Filter sind. Ein weiterer Vorteil ist darin zu sehen, daß die Weiterverarbeitung der demodulierten Signale, also beispielsweise die Decodierung des Rechts- und des Links-Signals sowie die weitere Verarbeitung der Signale des Informationskanals, zusammen mit der digitalen Demodulation innerhalb einer einzigen monolithisch integrierten Schaltung ermöglicht wird.

Die Erfindung wird nun anhand der Figuren der Zeichnung näher erläutert:

Fig. 1      zeigt ein schematisiertes Blockschaltbild eines Ausführungsbeispiels der Erfindung,

Fig. 2      zeigt das Frequenzschema eines MPX-Signals mit zusätzlichem Informationskanal,

Fig. 3      zeigt in schematischer Form Ausführungsbeispiele für die Korrekturschaltung von Quadratursignalpaaren,

Fig. 4      zeigt den zeitlichen Verlauf der Träger, und

Fig. 5      zeigt schematisch ein besonders einfaches Ausführungsbeispiel einer Dezimierschaltung.

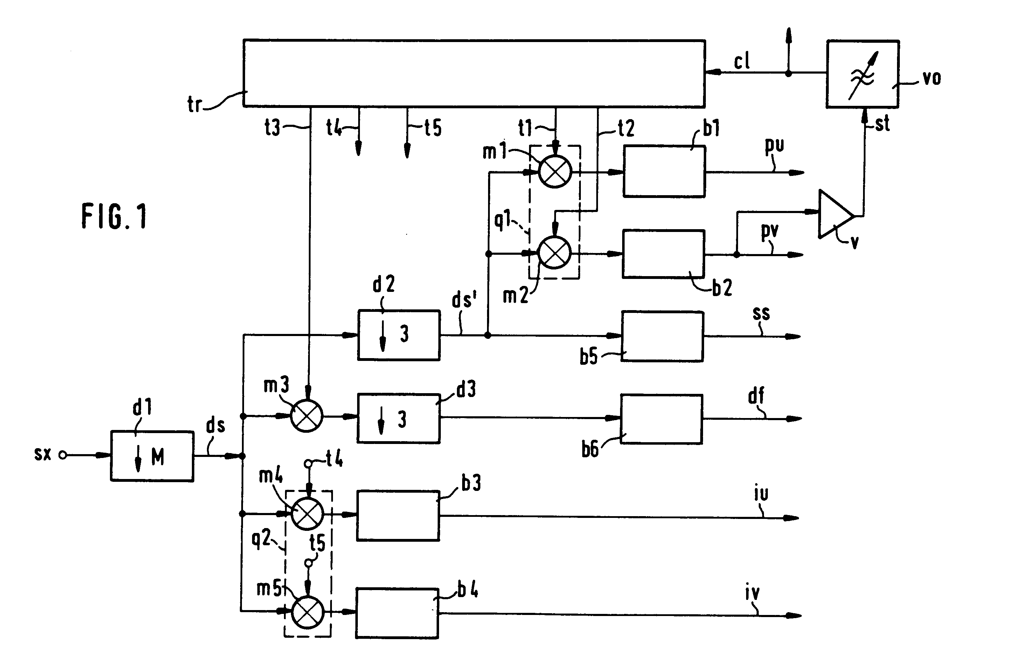

Im schematischen Schaltbild der Fig. 1 ist das digitalisierte MPX-Signal $sx$ der ersten Dezimierschaltung $d1$ zugeführt. In Abhängigkeit von der eingangsseitigen Digitalisierungsrate $fa$ eines vorangehenden Analog/Digital-Wandlers, der nicht dargestellt ist, oder einer ebenfalls nicht dargestellten vorangehenden digitalen Signalverarbeitungsschaltung wird der Dezimierfaktor $M$ so gewählt, daß die ausgangsseitige Abtastrate der ersten Dezimierschaltung $d1$ gleich dem Zwölffachen der Pilotsignalfrequenz $fp$ ist.

Die Reduktion der Abtastrate hat bekanntlich den Vorteil, daß die Taktfrequenz nachfolgender Teilschaltungen niedriger wird und daß sich damit die digitalen Filterschaltungen mit weniger Stufen und mit entsprechend kleinerem Flächenbedarf einer integrierten Schaltung herstellen lassen. Daher ist es vorteilhaft, die Abtastrate jeweils an die zu verarbeitende maximale Nutz-Signalfrequenz anzupassen. Der doppelte Wert der Nutz-Signalfrequenz darf dabei aber nicht unterschritten werden. Im Regelfall enthält jede Dezimierschaltung einen Filterteil, der Aliasing bei der Dezimierung vermeidet und einen elektronischen Schalter, der mit der ausgangsseitigen Abtastfrequenz die gefilterten Signale an die erwähnten Teilschaltungen weitergibt. Der jeweilige Dezimierfaktor der Abtastfrequenz ist bei den Dezimierschaltungen der Fig. 1 als Wert hinter einem nach unten weisenden Pfeil angegeben.

Das Ausgangssignal der ersten Dezimierschaltung $d1$ ist das erste dezimierte Signalgemisch $ds$, das als Eingangssignal die zweite Dezimierschaltung $d2$ speist, deren Dezimierfaktor 3 ist.

Der Ausgang der zweiten Dezimierschaltung $d2$ ist mit dem Signaleingang des ersten und des zweiten digitalen Demodulators $m1$, $m2$ verbunden, deren jeweiliger Trägereingang mit dem ersten bzw. dem dazu um 90° in der Phase gedrehten zweiten Träger $t1$, $t2$ gespeist ist, wobei diese zusammen den ersten Quadraturdemodulator $q1$ bilden. Das Ausgangssignal der zweiten Dezimierschaltung $d2$ ist das zweite dezimierte Signalgemisch $ds'$.

Wie bereits in der Offenlegungsschrift DE-A-33 14 603 beschrieben ist, gestalten sich digitale Modulatoren und Demodulatoren besonders einfach, wenn von den an sich zuzuführenden sinusförmigen Trägern nur deren vorzugsweise normierte Werte bei 0°, 90°, 180° und 270° benutzt werden, weil dann die Werte dieses quantisierten Trägers nur aus den leicht zu digitalisierenden Werten +1, -1 und 0 bestehen. Der digitale Modulator und Demodulator muß für diese speziellen Werte allenfalls das Vorzeichen des digitalisierten Eingangssignals ändern oder statt dessen als Ausgangssignal den Wert 0 weitergeben.

Die Ausgangssignale des ersten bzw. des zweiten digitalen Demodulators $m1$, $m2$ werden im ersten bzw. zweiten Tiefpaß $b1$, $b2$ von allen höheren und störenden Frequenzkomponenten befreit, insbesondere von Signalen aus dem benachbarten Audiofrequenzbereich, und erscheinen somit quasi als stationäre Signale, nämlich als die in den Frequenzursprung transformierte Inphase- bzw. Quadraturkomponente $pu$, $pv$ des Pilotsignals $ps$. Die Signalfrequenz fs, also die Grundfrequenz des ersten und des zweiten Trägers t1, t2, ist dabei gleich der Pilotsignalfrequenz fp, nämlich 19 kHz, während die Abtastfrequenz fa das Vierfache davon ist. Die Abtastfrequenz der am Ausgang des ersten und des zweiten digitalen Modulators m1, m2 abgegebenen Signale ist im Verhältnis zu ihrer gleichsam bei null liegenden Signalfrequenz sehr hoch, so daß eine starke Dezimierung der Abtastrate nach dem ersten und zweiten Demodulator m1, m2 angebracht ist. Diese Dezimierung vereinfacht wie beschrieben den nachgeschalteten ersten bzw. zweiten Tiefpaß b1, b2, wobei dann die jeweils ein- oder mehrstufige Dezimierschaltung dem jeweiligen Tiefpaß b1, b2 als ergänzende Teilschaltung zuzurechnen ist.

Das erste dezimierte Signalgemisch ds ist zur Trennung seiner weiteren Signalkomponenten ferner dem jeweiligen Signaleingang des dritten, des vierten und des fünften digitalen Demodulators m3, m4, m5 zugeführt, deren jeweiliger Trägereingang mit dem dritten bzw. vierten bzw. fünften Träger t3, t4, t5 gespeist ist. Dabei handelt es sich gleichfalls um digitalisierte sinus- bzw. cosinusförmige Signale, die ebenfalls wie bei dem ersten Trägerpaar t1, t2 nur die drei Werte +1, -1 und 0 aufweisen.

Die Abtastfrequenz dieser drei Träger t3, t4, t5 beträgt dabei jeweils 12fp. Die Frequenz des dritten Trägers t3 ist gleich 2fp, während die des vierten und fünften Trägers t4, t5 jeweils 3fp beträgt, wobei der Träger t4 der sinusförmige und der Träger t5 der cosinusförmige ist, also die beiden Träger t4, t5 um 90° gegeneinander in der Phase verschoben sind.

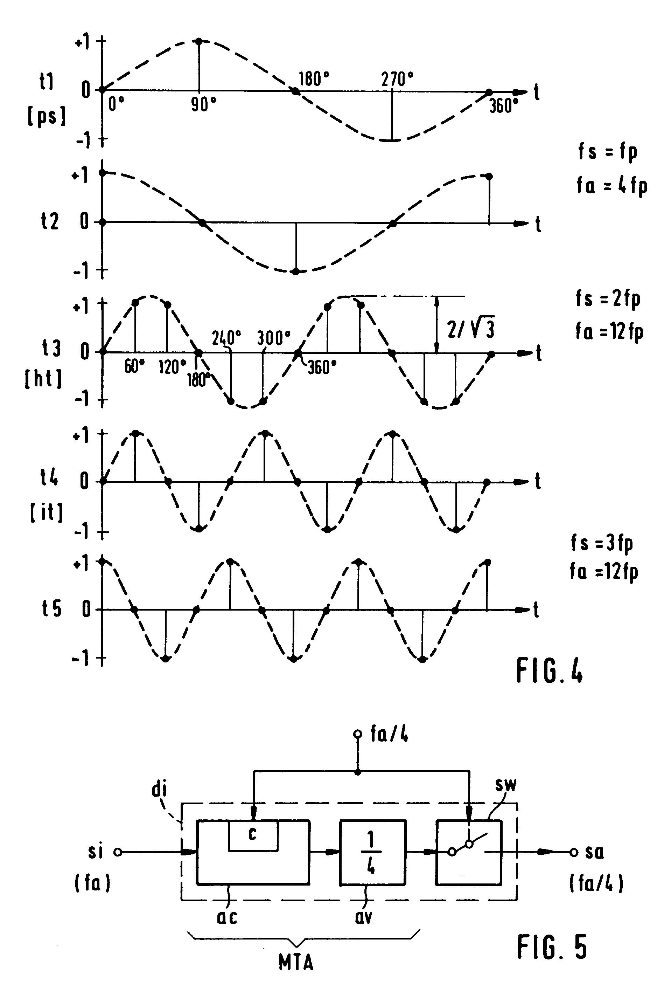

Der vierte und der fünfte Träger t4, t5 sind bei 0°, 90°, 180° und 270° digitalisiert, wobei die Signalamplitude auf eins normiert ist. Der dritte Träger t3 ist pro Signal-periode bei den Winkeln 0°, 60°, 120°, 180°, 240°, 300°, 360°... abgetastet. Die zugehörige sinusförmige Signalkurve hat die Amplitude $2(3^{-1/2})$, vgl. Fig. 4.

Der vierte und der fünfte digitale Demodulator m4, m5 bilden zusammen den zweiten Quadraturdemodulator q2. Die Amplituden des Stereo-Summensignals ss und des demodulierten Stereo-Differenzsignals df sind im Standard-MPX-Signal so gewählt, daß durch Summen- oder Differenzbildung dieser Signale, wie sie beispielsweise in Stereo-Decodern üblich ist, unmittelbar die Signale für das Links- bzw. das Rechts-Signal entstehen. Da die Demodulation des als Zweiseitenbandsignal vorliegenden Stereo-Differenzsignals df* beim Gegenstand der Erfindung durch einen multiplizierenden Demodulator erfolgt, geht die Amplitude des Trägers als Multiplikationsfaktor in die Amplitude des demodulierten Stereo- Differenzsignals df mit ein. Demnach ist das demodulierte Stereo-Differenzsignal df um diesen Faktor zu groß und muß bei der Weiterverarbeitung gegenüber dem Stereo-Summensignal ss um diesen Faktor reduziert werden.

Da vom Ausgangssignal des dritten digitalen Demodulators m3 nur das demodulierte bis maximal 15 kHz reichende Stereo-Differenzsignal df als Nutzsignal weiter zu verarbeiten ist, ist die Abtastrate 12fp dieses noch nicht von seinen Störkomponenten befreiten Ausgangssignals unnötig hoch. Ferner ist die hierbei erwünschte Abtastrate an die des ausgangsseitigen Stereo-Summensignals ss anzupassen, damit die gemeinsame weitere Verarbeitung beider Signale df, ss, beispielsweise in dem bereits erwähnten, jedoch in Fig. 1 nicht dargestellten, Stereodecoder, erleichtert wird. Daher ist dem dritten digitalen Demodulator m3 die zur zweiten Dezimierschaltung d2 bezüglich der Dezimierung identische dritte Dezimierschaltung d3 nachgeschaltet.

Im Ausgangssignal des vierten bzw. fünften digitalen Demodulators m4, m5 ist als interessierende Komponente die Inphasen- bzw. Quadraturkomponente iu, iv des Informationssignals enthalten, die mittels des dritten bzw. vierten Tiefpasses b3, b4, der an den Ausgang des vierten bzw. fünften digitalen Demodulators m4, m5 angeschlossen ist, ausgefiltert werden. Der Durchlaßbereich des dritten und des dazu identischen vierten Tiefpasses b3, b4 entspricht dabei etwa der halben Bandbreite des Informationskanals ik.

Das Ausgangssignal der zweiten Dezimierschaltung d2, nämlich das zweite dezimierte Signalgemisch ds′, enthält als Nutzsignale das Stereo-Summensignal ss und das Pilotsignal ps, das nach dem FM-Rundfunk-Stereo-Standard bei 19 kHz liegt und als Störsignale die oberhalb 19 kHz liegenden Frequenzanteile des MPX-Signals sx, insbesondere das nichtdemodulierte Stereo-Differenzsignal df* im Bereich von 23 kHz bis 53 kHz, aber auch die Alias-Signale und eventuell vorhandene Rauschanteile enthält. Die Störsignale werden mittels Tiefpaßfilterung unterdrückt. Der zweiten Dezimierschaltung d2 ist daher zur Erzeugung des Stereo-Summensignals ss der fünfte Tiefpaß b5 nachgeschaltet, dessen Sperrbereich oberhalb der maximal möglichen Audio-Signalfrequenz beginnt. Mögliche Restanteile des Pilotsignals ps im Stereo-Summensignal ss stören dabei kaum, denn diese lassen sich bei der weiteren Signalverarbeitung leicht herausfiltern, da sie lediglich die Frequenz des Pilotsignals ps haben.

Der Erzeugung des demodulierten Stereo-Differenzsignals df aus dem Ausgangssignal der dritten Dezimierschaltung d3 dient der dieser nachgeschaltete sechste Tiefpaß b6, der bezüglich seines Durchlaß- und Sperrbereichs identisch mit dem des fünften Tiefpasses b5 ist. Als Störsignalgemisch im Ausgangssignal der dritten Dezimierschaltung d3 wirken die Alias-Signale und eventuell vorhandene Rauschanteile, insbesondere jedoch das in den Bereich von 23 kHz bis 53 kHz transformierte Stereo-Summensignal. Das Pilotsignal ps liegt wieder bei 19 kHz, wobei Restanteile im demodulierten Stereo-Differenzsignal df bei der weiteren Signalverarbeitung leicht ausfilterbar sind.

Innerhalb des fünften und sechsten Tiefpasses b5, b6 ist eine weitere Dezimierung, beispielsweise um den Dezimierungsfaktor 2, von Vorteil, weil die maximal mögliche Audio-Signalfrequenz (15 kHz) die weitere Reduktion der Abtastrate von 76 kHz auf 38 kHz nach der zweiten und dritten Dezimierschaltung d2, d3 erlaubt.

Alle sechs Tiefpässe b1 ... b6 dienen somit der Befreiung der interessierenden Signalkomponenten von anderen Signalkomponenten. Diese können die durch die Abtastung bedingten Alias-Signale oder die stets vorhandenen Rauschsignale oder auch Komponenten des digitalisierten MPX-Signals sx sein, die durch die Frequenzumsetzung in den digitalen Demodulatoren m1.... m5 in eine andere Frequenzlage gebracht werden. Vorzugsweise können die sechs Tiefpässe b1 ... b6 dabei auch weitere Dezimierschaltungen enthalten, um die Abtastrate weiter zu reduzieren, wobei der Wert der doppelten maximal möglichen Frequenz der jeweiligen Signalkomponente nicht unterschritten werden darf.

In Fig. 1 wird die in die Frequenzursprungslage transformierte Quadraturkomponente pv des Pilotsignals ps im Verstärker v verstärkt und danach als Steuersignal st dem in Frequenz und Phase einstellbaren Oszillator vo zugeführt. Sein Ausgangssignal ist das Systemtaktsignal cl. Dieses steuert die Trägeraufbereitungsschaltung tr, die beispielsweise über Frequenzteiler die fünf digitalen Träger t1 ... t5 erzeugt. Dabei ist der einstellbare Oszillator vo Teil einer PLL-Schleife (= phase-locked loop), die über die Trägeraufbereitungsschaltung tr, einen der fünf Träger t1 ... t5 mit zugehörigem digitalen Demodulator m1 ... m5 und zugehörigem Tiefpaß b1 ... b4, b6, sowie das Steuersignal st geschlossen ist. Im einfachsten Fall dient, wie in Fig. 1 dargestellt, als Phasenvergleichssignal die mittels des Verstärkers v verstärkte Quadraturkomponente pv des Pilotsignals ps in der Frequenzursprungslage. Größe und Vorzeichen dieses Signals stellen dabei die Winkelabweichung des ersten Trägers t1 vom empfangenen Pilotsignal ps dar. Die PLL-Schleife ist bestrebt, diesen Fehler und damit auch die Quadraturkomponente pv auf null zu regeln.

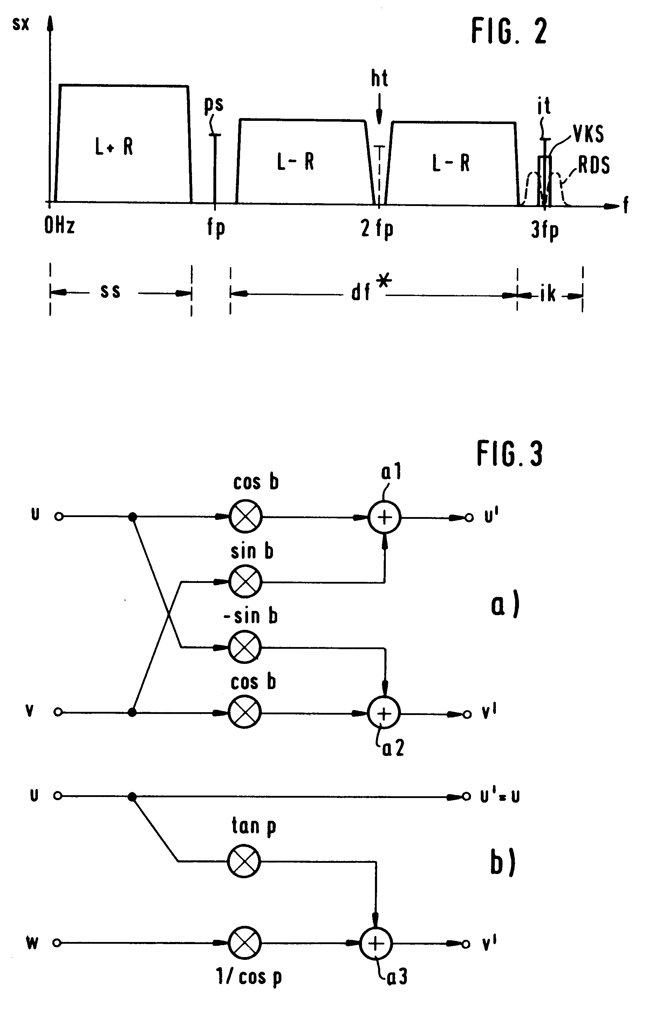

Fig. 2 zeigt in analoger Darstellung das Frequenzschema des digitalisierten Signalgemisches, welches das digitalisierte MPX-Signal sx einschließlich des Informationskanals ik zeigt. Der Stereo-Hilfsträger ht des Stereo-Differenzsignals df* ist im Idealfall vollständig unterdrückt. Der Informationskanal ik beim Informationsträger it ist schmalbandig im Vergleich zu den Audiosignalen. Mit Vollstrich ist schematisch der Bereich des Verkehrs-Kennungs-Signals (= VKS) und der zugehörige Informationsträger it bei der dreifachen Frequenz 3fp des Pilotsignals ps angegeben. Gestrichelt ist schematisch der Frequenzbereich des Radio-Daten-Signals (= RDS) gezeigt, dessen Träger um 90° gegenüber dem Informationsträger it phasenverschoben und unterdrückt ist. Diese beiden Informationssignale VKS, RDS können voneinander getrennt werden, wenn die zugehörigen in Quadratur stehenden Komponenten bei der Frequenzumsetzung mittels des vierten bzw. fünften Trägers t4, t5 mit richtiger Phase vorliegen.

Die Phasenbeziehungen des Pilotsignals ps, des Stereo-Hilfsträgers ht und des Informationsträgers it im MPX-Signal sx sind senderseitig so festgelegt, daß beim positiven Nulldurchgang des Pilotsignals ps sowohl der Stereo-Hilfsträger ht als auch der Informationsträger it einen Nulldurchgang mit positiver Steigung aufweisen. Damit hat auch die jeweilige Inphasenkomponente zu diesem Zeitpunkt einen solchen Nulldurchgang, also einen sinusförmigen Verlauf.

In der Praxis kann beim analogen oder digitalisierten MPX-Signal sx die Phasenbeziehung zwischen dem Pilotsignal ps, dem Hilfsträger ht und dem Informationsträger it gestört sein, weil vorangehende Filterschaltungen oder auch die digitalen Filter, z.B. in der zweiten Dezimierschaltung d2, eine Phasenabweichung bewirken. Dann enthalten die getrennten Komponenten des MPX-Signals sx Störsignale, z.B. Signalanteile der jeweiligen anderen Quadraturkomponente, die die spätere Decodierung erschweren.

Zur einwandfreien Phasenlage muß daher das erste Quadratur-Signalpaar pu, pv des Pilotsignals ps in der Frequenzursprungslage mittels einer ersten Korrekturschaltung korrigiert werden, die die Funktion einer Winkeldrehung dieser Signale um den ersten Korrekturwinkel hat, vergleiche z.B. Fig. 3a. Ebenso muß das Quadratur-Signalpaar iu, iv des Informationssignals mittels einer zweiten Korrekturschaltung um den zweiten Korrekturwinkel gedreht werden. Der jeweilige Korrekturwinkel ergibt sich beispielsweise durch Auswertung entsprechender Testsignale im MPX-Signal sx. Die Korrekturschaltungen können seitens des Herstellers fest eingestellt sein, und die entsprechenden Korrekturwerte berücksichtigen die gesamte Empfangsschaltung.

Wenn das Pilotsignal ps im MPX-Signal sx nicht vorhanden ist, dann kann zur Demodulation des Informationskanals ik die PLL-Schleife auch über den Informationsträger it und den mit ihm verkoppelten vierten Träger t4 geschlossen werden. Dabei ist ein üblicher Phasenvergleicher erforderlich, dem der Informationsträger it und ein aus dem Systemtakt c1 abgleitetes Signal mit der Frequenz des Informationsträgers it zugeführt sind.

Ist im Informationskanal ik jedoch nur das RDS-Signal, dessen Träger unterdrückt ist, enthalten, so ergibt sich die Schließung der PLL-Schleife ohne Pilotsignal ps z.B. aus der Offenlegungsschrift DE-A-34 33 592.

Fig. 3a zeigt schematisch ein Ausführungsbeispiel der Korrekturschaltung. Das Inphasensignal u wird mit dem Cosinuswert des Korrekturwinkels b multipliziert und dem ersten Eingang des ersten Addierers a1 zugeführt; ferner wird es mit dem negativen Sinuswert des Korrekturwinkels b multipliziert und dem ersten Eingang des zweiten Addierers a2 zugeführt. Das Quadratursignal v wird mit dem Sinuswert des Korrekturwinkels b multipliziert und dem zweiten Eingang des ersten Addierers a1 zugeführt; ferner wird es mit dem Cosinuswert des Korrekturwinkels b multipliziert und dem zweiten Eingang des zweiten Addierers a2 zugeführt. Das Ausgangssignal des erstes Addierers a1 ist das korrigierte Inphasen-Ausgangssignal $u'$, und das Ausgangssignal des zweiten Addierers a2 ist das korrigierte Quadratur-Ausgangssignal $v'$.

Fig. 4 zeigt schematisch in analoger Darstellung den zeitlichen Verlauf der fünf digitalen Träger t1 ... t5, wobei der erste und zweite Träger t1, t2 das erste Quadratursignalpaar und der vierte und fünfte Träger t4, t5 das zweite bilden. Fig. 4 zeigt ferner im Vergleich zur Pilotsignalfrequenz fp die jeweils zugehörige Trägerfrequenz fs, die sich aus dem geglätteten Signalverlauf,
der jeweils gestrichelt gezeichnet ist, ergibt. Die jeweils zugehörige Abtastfrequenz fa ist ebenfalls angegeben. Schließlich ist für den ersten und den dritten Träger t1, t3 der jeweilige Abtastzeitpunkt als Winkelwert in Grad eingetragen. Außer dem dritten Träger t3 weisen alle anderen Signale die normierte Amplitude eins auf. Die Amplitude des dritten Trägers t3 beträgt indessen $2(3^{-1/2})$.

Die zeitlichen Beziehungen zwischen den einzelnen Trägern t1 ... t5 gelten für den idealisierten Fall, daß das Filter in der zweiten Dezimierschaltung d2 keine Phasenverschiebung des Pilotsignals ps bewirkt. Ist dies nicht der Fall, kann die Phasenverschiebung des Pilotsignals ps durch die in Fig. 3a gezeigte Korrekturschaltung kompensiert werden.

In Fig. 4 sind ferner in Rechteckklammern die dem ersten bzw. dritten bzw. vierten Träger t1, t3, t4 entsprechenden MPX-Komponentensignale eingetragen, nämlich das Pilotsignal ps bzw. der Stereo-Hilfsträger ht bzw. der Informationsträger it.

Fig. 5 zeigt ein besonders einfaches Ausführungsbeispiel einer Dezimierschaltung di, die die Abtastfrequenz fa des digitalisierten Eingangssignals si durch 4 teilt. Das eingangsseitige Dezimationsfilter besteht aus dem Akkumulator ac, der jeweils vier Eingangsabtastwerte aufsummiert, bis er durch ein Löschsignal an seinem Eingang c auf null zurückgesetzt wird. Das Ausgangssignal des Akkumulators ac wird im nachfolgenden Dividierer av durch 4 geteilt und über den elektronischen Schalter sw, der nur bei jedem vierten Impuls des Eingangsabtastsignals, also mit der Frequenz fa/4 geschlossen wird, als dezimiertes Ausgangssignal sa abgegeben.

Die Teilschaltung mit dem Akkumulator ac und dem Dividierer av wird auch als "gleitender Mittelwertbildner" (= Moving-Time-Averager = MTA-Filter) bezeichnet. Sie besitzt eine Übertragungsfunktion, die bei allen ganzzahligen Vielfachen der dezimierten Abtastfrequenz eine Nullstelle aufweist.

In Fig. 5 ergibt sich z.B. die Übertragungsfunktion zu

$$H(z) = (1 + z^{-1} + z^{-2} + z^{-3})/A.$$

Dabei ist A der Divisor des Dividierers av, der vorzugsweise eine Zweierpotenz ist und in Fig. 5 den Wert 4 hat. Diese spezielle Dezimierschaltung di läßt sich nur bei schmalbandigen Signalen, z.B. beim Informationskanal ik, anwenden. In allen anderen Fällen ist vor dem elektronischen Schalter sw ein aufwandigerer digitaler Tiefpaß erforderlich.

Das einfache MTA-Filter von Fig. 5 mit seiner kammartigen Durchlaßkurve ist nur dann zulässig, wenn die Frequenzen des durchzulassenden Frequenzbandes sehr klein gegenüber der dezimierten Abtastfrequenz sind, weil sonst die oberen Signalfrequenzen durch die Durchlaßkurve in der Amplitude verändert werden.

Bei einem High-Quality-Stereo- Überträgungsverfahren, wie es in der US-A-44 85 483 beschrieben ist, ist der Stereo-Hilfsträger ht durch einen dazu in Quadratur stehenden zweiten Hilfsträger ergänzt und wird mit einer Zusatzinformation moduliert. Zur Demodulation dieses Signals ist ein sechster Träger erforderlich, der zum dritten Träger t3 in Quadratur stehen muß. Fig. 4 zeigt, das dies nach dem Schema des ersten und zweiten Quadratursignalpaares nicht möglich ist, weil die Abtastwerte des dritten Trägers t3 und des sechsten Trägers jeweils bei Vielfachen von 60° liegen würden. Der sechste Träger hätte demnach gegenüber dem dritten Träger t3 eine Phasenverschiebung von 60° oder 120°, statt der gewünschten 90°.

Der sechste Träger mit der falschen Phasenlage erzeugt somit bei der digitalen Demodulation auch nicht als Quadraturkomponente $v'$ das gewünschte zusätzliche Signal, sondern eine um den Winkel p, z.B. 30°, abweichende fehlerhafte Komponente w. Die gewünschte Quadraturkomponente $v'$ kann daraus aber durch eine Winkeldrehung um den Winkel p ermittelt werden. Dies ist beispielsweise mittels der weiteren Korrekturschaltung nach Fig. 3b möglich.

Das Inphasensignal $u'$, das nicht korrigiert werden muß, ist dem eingangsseitigen Inphasensignal u gleich. Die gewünschte Quadraturkomponente $v'$ ergibt sich aus der Summe des mit dem Tangenswert des Winkels p multiplizierten Inphasensignals u und der mit dem reziproken Cosinuswert des Winkels p multiplizierten fehlerhaften Komponente w. Die Summe wird im dritten Addierer a3 gebildet, dessen Ausgangssignal somit die korrigierte Komponente, nämlich die gewünschte Quadraturkomponente $v'$, ist.

Da die Korrekturschaltungen nach Fig. 3 im wesentlichen jedoch eine rein arithmetische Signalverarbeitung bewirken, wird diese zweckmäßigerweise in den erwähnten Decoderteil verlegt, der die demodulierten MPX-Signalanteile digital weiterverarbeitet.

## Patentansprüche

1. Digitaler Demodulator
   - mit mindestens einem ersten Quadraturdemodulator (q1), der einen ersten und einen zweiten digitalen Demodulator (m1, m2) enthält,
   - mit mindestens einer ersten Dezimierschaltung (d1), die ein erstes dezimiertes Signalgemisch (ds) aus einem digitalisierten Signalgemisch erzeugt,
     - wobei dem ersten bzw. zweiten digitalen Demodulator (m1, m2) als Eingangssignale ein zweites dezimiertes Signalgemisch $(ds')$ und ein digitalisierter sinusförmiger erster Träger (t1) bzw. ein consinusförmiger zweiter, mit dem ersten gleichfrequenter Träger (t2) zugeführt sind, die jeweils bei 0°, 90°, 180°, 270°, 360° ... abgetastet sind und die daraus gebildeten Digitalwortfolgen gleich 0, +1, 0, -1, 0 ... bzw. +1, 0, -1, 0, +1 ... sind und
     - wobei die Digitalisierungsfrequenz des jeweiligen Trägers (t1, t2) gleich der Abtastfrequenz des zweiten dezimierten Signalgemisches $(ds')$ ist und in einem einfachen ganzzahligen Verhältnis zur Trägerfrequenz steht, und
   - mit einer Trägeraufbereitungsschaltung (tr), die den ersten und zweiten Träger (t1, t2) erzeugt und die durch ein aus dem zweiten dezimierten Signalgemisch $(ds')$ abgeleitetes Signal gesteuert ist, gekennzeichnet durch folgende Merkmale:
     - das Eingangssignal der ersten Dezimierschaltung (d1) ist ein digitalisiertes Standard-Stereo-Multiplex-Signal (= MPX-Signal) (sx) mit einem schmalbandigen Informationskanal (ik) bei der dreifachen Frequenz eines im MPX-Signal (sx) enthaltenen Pilotsignals (ps) der Frequenz fp,
   - die Frequenz des ersten bzw. des zweiten Trägers (t1 t2) ist gleich der des Pilotsignals (ps),
   - die Trägeraufbereitungsschaltung (tr) ist Teil einer PLL-Schleife, die auf das Pilotsignal (ps) oder einen im Informationskanal (ik) vorhandenen Informationsträger (it) einrastet und einen dritten, einen vierten sowie einen fünften Träger (t3, t4, t5) erzeugt, wobei
     - diese mit der Frequenz 12fp digitalisiert sind und die daraus gebildeten Digitalwortfolgen nur die Werte +1, -1 oder 0 enthalten,
     - der dritte Träger (t3) die Frequenz 2fp hat, bei 0°, 60°, 120°, 180°, 240°, 300°, 360° ... digitalisiert, die zugehörige Digitalwortfolge gleich 0, +1, +1, 0, -1, -1, 0 ... und einem dritten digitalen Demodulator (m3) zugeführt ist, und
     - als Quadratursignalpaar der vierte und der fünfte Träger (t4, t5) dienen, wobei diese jeweils die Frequenz 3fp haben, bei 0°, 90°, 180°, 270°, 360° ... abgetastet, die daraus gebildeten Digitalwortfolgen gleich 0, +1, 0, -1, 0 ... bzw. +1, 0, -1, 0, +1 ... und einem vierten bzw. einem fünften digitalen Demodulator (m4, m5) zugeführt sind,
   - der Ausgang der ersten Dezimierschaltung (d1), welche die Abtastfrequenz auf die Frequenz 12fp absenkt, ist mit dem Eingang einer zweiten Dezimierschaltung (d2), welche die Abtastfrequenz auf die Frequenz 4fp absenkt und das zweite dezimierte Signalgemisch $(ds')$ liefert, und mit dem jeweiligen Signaleingang des dritten, vierten und fünften digitalen Demodulators (m3, m4, m5) verbunden,
   - der Ausgang des dritten digitalen Demodulators (m3) ist mit dem Eingang einer zur zweiten Dezimierschaltung (d2) identischen dritten Dezimierschaltung (d3) verbunden, deren Ausgangssignal das demodulierte digitale Stereo-Differenzsignal (df) enthält,
   - die Ausgangssignale des ersten und des zweiten digitalen Demodulators (m1, m2) sind mittels eines ersten bzw. eines zweiten digitalen Tiefpasses (b1, b2) gefiltert, und diese stellen eine Inphasen- bzw. eine Quadraturkomponente (pu, pv) des Pilotsignals (ps) in der Frequenzursprungslage dar,

- der Ausgang des vierten bzw. fünften digitalen Demodulators (m4, m5) ist mit dem Eingang eines dritten bzw. eines dazu identischen vierten Tiefpasses (b3, b4) verbunden, deren Durchlaßbereich etwa gleich der halben Bandbreite des Informationskanals (ik) ist und deren Ausgangssignal ein Inphasen- bzw. ein Quadratur-Informationssignal (iu, iv) ist, und

- der Ausgang der zweiten bzw. der dritten Dezimierschaltung (d2, d3) ist mit dem Eingang eines fünften bzw. dazu identischen sechsten digitalen Tiefpasses (b5, b6) verbunden, deren Sperrbereiche oberhalb der maximal möglichen Audio-Signalfrequenz beginnen und deren Ausgangssignale jeweils das demodulierte Stereo-Summensignal (ss) bzw. das demodulierte Stereo-Differenzsignal (df) sind.

2. Digitaler Demodulator nach Anspruch 1, dadurch gekennzeichnet, daß mindestens einer der sechs Tiefpässe (b1 bis b6) mindestens eine weitere Dezimierschaltung enthält.

3. Digitaler Demodulator nach Anspruch 1 oder 2, dadurch gekennzeichnet, daß die PLL-Schleife einen in Frequenz und Phase einstellbaren Os-zillator (vo) und die Trägeraufbereitungsschal-tung (tr) enthält, wobei als Phasenvergleichssignal entweder die Quadraturkomponente (pv) des Pilotsignals (ps) oder ein aus dem Inphasen- oder Quadratur-Informationssignal (iu, iv) abgeleitetes Signal dient.

4. Digitaler Demodulator nach einem der Ansprüche 1 bis 3, dadurch gekennzeichnet, daß eine erste Korrekturschaltung die Inphasen- und die Quadraturkomponente (pu, pv) des Pilotsignals (ps) und/oder eine zweite Korrekturschaltung das Inphasen- und das Quadratur-Informationssignal (iu, iv) um einen ersten bzw. einen zweiten Korrekturwinkel dreht.

5. Digitaler Demodulator nach Anspruch 4, dadurch gekennzeichnet, daß die erste und die zweite Korrekturschaltung aus einem Inphasen-bzw. einem Quadratursignal u bzw. v eine kor-rigiertes Inphasen- bzw. Quadratur-Ausgangssi-gnal u' bzw. v' nach folgenden Bemessungsre-geln erzeugt:

$$u' = u \cos b + v \sin b$$

$$v' = v \cos b - u \sin b,$$

wobei b der jeweilige Korrekturwinkel ist.

6. Digitaler Demodulator nach einem der Ansprüche 1 bis 5, dadurch gekennzeichnet, daß mindestens einer der Tiefpässe (b1 bis b6) ein Moving-Time-Averaging-Filter (= MTA-Filter) (= Filter mit gleitender Mittelwertbildung) zur weiteren Dezimierung enthält.

7. Digitaler Demodulator nach einem der Ansprüche 1 bis 6, dadurch gekennzeichnet, daß er monolithisch integriert ist.

**Claims**

1. Digital demodulator comprising

- at least one first quadrature demodulator (q1) containing a first digital demodulator (m1) and a second digital demodulator (m2),

- at least one first decimation circuit (d1) which derives a first decimated composite signal (ds) from a digitized composite signal,

- the first and second digital demodulators (m1, m2) being fed by a second decimated composite signal (ds') and, respectively, by a digitized sinusoidal first carrier (t1) and a cosinusoidal second carrier (t2) having the same frequency as the first carrier (t1), which are sampled at 0°, 90°, 180°, 270°, 360°, ..., the digital-word sequences formed therefrom being equal to 0, +1, 0, -1, 0, ... and +1, 0, -1, 0, +1, ..., respectively, and

- the sampling rate of the respective carrier (t1, t2) being equal to the sampling rate of the second decimated composite signal (ds') and having a whole-number relationship to the carrier frequency, and

- a carrier-conditioning circuit (tr) which generates a first carrier (t1) and second carrier (t2) and is controlled by a signal derived from the second decimated composite signal (ds'),

characterized by the following features:

- The input to the first decimation circuit (d1) is a digitized standard stereo multiplex signal (= MPX signal) (sx) with a narrow-band information channel (ik) at three times the frequency of a pilot signal (ps) of frequency fp contained in the MPX signal (sx);

- the frequencies of the first and second carriers (t1, t2) are equal to the frequency of the pilot signal (ps);

- the carrier-conditioning circuit (tr) is part of a phase-locked loop which locks with the pilot signal (ps) or with an information carrier (it) present in the information channel (ik) and generates a third carrier (t3), a fourth carrier (t4), and a fifth carrier (t5),
  - the latter carriers being sampled at the frequency 12fp and the digital-word sequences formed therefrom containing only the values +1, -1, and 0,
  - the third carrier (t3) having the frequency 2fp and being sampled at 0°, 60°, 120°, 180°, 240°, 300°, 360°, ..., and the associated digital-word sequence being equal to 0, +1, +1, 0, -1, -1, 0, and being fed to a third digital demodulator (m3), and
  - the fourth and fifth carriers (t4, t5) serving as a quadrature-signal pair and having the frequency 3fp and being sampled at 0°, 90°, 180°, 270°, 360°, ..., and the digital-word sequences formed therefrom being equal to 0, +1, 0, -1, 0, ... and +1, 0, -1, 0, +1, ..., respectively, and being fed to a fourth digital demodulator (m4) and a fifth digital demodulator (m5), respectively;
- the output of the first decimating circuit (d1), which reduces the sampling frequency to the frequency 12fp is coupled to the input of a second decimation circuit (d2) which reduces the sampling frequency to the frequency 4fp and delivers the second decimated composite signal (ds'), and to the signal inputs of the third, fourth, and fifth digital demodulators (m3, m4, m5);
- the output of the third digital demodulator (m3) is coupled to the input of a third decimation circuit (d3) which is identical to the second decimation circuit (d2) and whose output contains the demodulated stereo difference signal (df);
- the outputs from the first and second digital demodulators (m1, m2) are filtered by means of a first digital low-pass filter (b1) and a second digital low-pass filter (b2), respectively, which provide an in-phase component (pu) and a quadrature component (pv), respectively, of the pilot signal (ps) at zero frequency;
- the outputs of the fourth and fifth digital demodulators (m4, m5) are coupled to the inputs of a third low-pass filter (b3) and a fourth low-pass filter (b4), respectively, which are identical in design, have a passband approximately equal to half the bandwidth of the information channel (ik), and provide an in-phase information signal (iu) and a quadrature information signal (iv), respectively, and

- the outputs of the second and third decimation circuits (d2, d3) are coupled to the inputs of a fifth digital low-pass filter (b5) and a sixth digital low-pass filter (b6), respectively, which are identical in design, have a stopband beginning above the maximum possible audio signal frequency, and provide the demodulated stereo sum signal (ss) and the demodulated stereo difference signal (df), respectively.

2. A digital demodulator as claimed in claim 1, characterized in that at least one of the six low-pass filters (b1 to b6) contains at least one additional decimation circuit.

3. A digital demodulator as claimed in claim 1 or 2, characterized in that the phase-locked loop contains a frequency- and phase-variable oscillator (vo) and the carrier-conditioning circuit (tr), with either the quadrature component (pv) of the pilot signal (ps) or a signal derived from the in-phase or quadrature information signal (iu, iv) serving as a phase-comparison signal.

4. A digital demodulator as claimed in any one of claims 1 to 3, characterized in that a first correction circuit rotates the in-phase and quadrature components (pu, pv) of the pilot signal (ps), and/or a second correction circuit rotates the in-phase and quadrature information signal (iu, iv) by a first correction angle and/or a second correction angle.

5. A digital demodulator as claimed in claim 4, characterized in that the first correction circuit and the second correction circuit derive a corrected in-phase signal (u') and a corrected quadrature signal (v') from an in-phase signal (u) and a quadrature signal (v), respectively, according to the following rules:

$$u' = u \cos b + v \sin b$$
$$v' = v \cos b - u \sin b$$

where b is the respective correction angle.

6. A digital demodulator as claimed in any one of claims 1 to 5, characterized in that at least one of the low-pass filters (b1 to b6) contains a moving-time-averaging filter (= MTA filter) for further decimation.

7. A digital demodulator as claimed in any one of claims 1 to 6, characterized in that it is implemented as a monolithic integrated circuit.

**Revendications**

1. Démodulateur numérique :
   - avec au moins un démodulateur en quadrature (q1), qui contient un premier et un deuxième démodulateurs numériques (m1, m2),
   - avec au moins un premier circuit de sous échantillonnage (d1) qui produit un premier mélange sous échantillonné de signaux (ds) à partir d'un mélange numérisé de signaux,
      - dans lequel, on envoie au premier, respectivement deuxième, modulateur numérique, comme signaux d'entrée, un deuxième mélange sous échantillonné de signaux (ds') et une première porteuse numérisée de forme sinusoïdale (t1), respectivement une deuxième porteuse en forme de cosinus (t2) de même fréquence que la première, qui sont décalés respectivement de 0°, 90°, 180°, 270°, 360° ... et la suite de mots numériques ainsi constituée est égale à 0, +1, 0, -1, 0... ou +1, 0, -1, 0, +1... et
      - dans lequel la fréquence de numérisation de la porteuse respective (t1, t2) est égale à la fréquence de balayage du deuxième mélange sous échantillonné de signaux (ds') et est dans une relation simple en nombres entiers avec la fréquence porteuse, et
   - avec un circuit de mise en forme de porteuse (tr) qui produit la première et la deuxième porteuses (t1, t2) et est commandé par un signal extrait du deuxième mélange sous échantillonné de signaux (ds'),
   caractérisé en ce que :
   - le signal d'entrée du premier circuit de sous échantillonnage (d1) est un signal numérisé stéréophonique multiplex standard (ou signal MPX) (sx) avec un canal d'informations à bande étroite (ik) à une fréquence triple de la fréquence $f_p$ d'un signal pilote (ps) contenu dans le signal MPX (sx),
   - la fréquence de la première et de la deuxième porteuses (t1, t2) est égale à celle du signal pilote (ps),
   - le circuit de mise en forme de porteuse (tr) fait partie d'une boucle PLL qui est calée sur le signal pilote (ps) ou sur une porteuse d'information (it) présente dans le canal d'informations (ik), et produit une troisième, une quatrième ainsi qu'une cinquième fréquences porteuses (t3, t4, t5),
      - ces porteuses sont numérisées à la fréquence 12 fp et les séquences de mots numériques ainsi constituées contiennent seulement les valeurs +1, -1 ou 0,
      - la troisième porteuse (t3) qui a la fréquence 2 fp est numérisée à 0°, 60°, 120°, 180°, 240°, 300°, 360° ..., la suite de mots numériques associés est égale à 0, +1, +1, 0, -1, -1, 0... et est envoyée à un troisième démodulateur numérique (m3), et
      - comme paire de signaux en quadrature on utilise la quatrième et la cinquièmre porteuses (t4, t5) qui ont chacune la fréquence 3 fp, sont décalées de 0°, 90°, 180°, 270°, 360°..., les suites de mots numériques constituées à partir d'elles sont égales à 0, +1, 0, -1, 0... ou +1, 0, -1, 0, +1... et sont envoyées à un quatrième ou à un cinquièmre démodulateur (m4, m5),
   - la sortie du premier circuit de sous échantillonnage (d1) qui abaisse la fréquence de balayage à la fréquence 12 fp est reliée à l'entrée d'un deuxième circuit de sous échantillonnage (d2) qui abaisse la fréquence de balayage à la fréquence 4 fp et délivre le deuxième mélange sous échantillonné de signaux (ds'), et est reliée avec les entrées respectives de signaux du troisième, du quatrième et du cinquièmre démodulateurs numériques (m3, m4, m5),
   - la sortie du troisième démodulateur numérique (m3) est reliée à l'entrée d'un troisième circuit de sous échantillonnage (d3), identique au deuxième circuit de sous échantillonage d2) et dont le signal de sortie contient le signal numérique démodulé stéréophonique de différence (df),
   - les signaux de sortie du premier et du deuxième démodulateurs numériques (m1, m2) sont filtrés au moyen d'un premier, respectivement d'un deuxième, filtre numérique passe-bas (b1, b2) et représentent des composantes en phase ou en quadrature (pu, pv) du signal pilote (ps) dans la situation de fréquence initiale,

- la sortie du quatrième, respectivement du cinquièmre, démodulateur numérique (m4, m5) est reliée à l'entrée d'un troisième, respectivement d'un quatrième, filtre passe-bas (b3, b4) qui lui est identique, dont la bande passante est sensiblement égale à la moitié de la largeur de bande du canal d'information (ik) et dont le signal de sortie est un signal d'information en phase ou en quadrature (iu, iv), et

- la sortie du deuxième, respectivement du troisième, circuit de sous échantillonnage (d2, d3) est reliée à l'entrée d'un cinquièmre, respectivement sixième, filtre numérique passe-bas qui lui est identique (b5, b6), dont les bandes éliminées commencent au-dessus de la fréquence maximale possible de signal audiophonique et dont les signaux de sortie sont respectivement le signal démodulé stéréophonique de somme (ss) ou le signal démodulé stéréophonique de différence (df).

2. Démodulateur numérique selon la revendication 1, caractérisé en ce qu'au moins un des six filtres passe-bas (b1 à b6) contient au moins un autre circuit de sous échantillonnage.

3. Démodulateur numérique selon la revendication 1 ou 2, caractérisé en ce que la boucle PLL contient un oscillateur (o) réglable en fréquence et en phase et le circuit de mise en forme de porteuse (tr), soit les composantes en quadrature (pv) du signal pilote (ps), soit un signal extrait du signal d'information en phase ou en quadrature (iu, iv), servant de signal de comparaison de phase.

4. Démodulateur numérique selon l'un des revendications 1 à 3, caractérisé en ce qu'un premier circuit de correction fait tourner d'un premier angle de correction les composantes en phase et en quadrature (pu, pv) du signal pilote (ps) et/ou un deuxième circuit de correction fait tourner d'un deuxième angle de correction le signal d'information en phase et en quadrature (iu, iv).

5. Démodulateur numérique selon la revendication 4, caractérisé en ce que le premier et le deuxième circuits de correction produisent un signal de sortie corrigé en phase ou en quadrature (u' ou v') à partir d'un signal en phase ou en quadrature (u ou v) au moyen des formules suivantes :

$$u' = u \cos b + v \sin b$$
$$v' = v \cos b - u \sin b$$

dans lesquelles b est l'angle de correction respectif.

6. Démodulateur numérique selon une des revendications 1 à 5, caractérisé en ce qu'au moins un des filtres passe-bas (b1 à b6) contient un filtre à moyenne mobile dans le temps (filtre MTA) pour un sous échantillonnage supplémentaire.

7. Démodulateur numérique selon une des revendications 1 à 6, caractérisé en ce qu'il est intégré de manière monolithique.

FIG.1

# FIG. 2

# FIG. 3

a)

b)

FIG. 4

FIG. 5